# EUROPEAN PATENT SPECIFICATION

(11) **EP 3 836 206 B1**
(45) Date of publication and mention of the grant of the patent: **07.05.2025**
(21) Application number: 19216160.2
(22) Date of filing: 13.12.2019
(51) Int. Cl.: H01L 23/473, F28F 9/02

(54) **COOLING DEVICE FOR SEMICONDUCTOR SWITCHING ELEMENTS, POWER INVERTER DEVICE, ARRANGEMENT AND MANUFACTURING METHOD**
KÜHLVORRICHTUNG FÜR HALBLEITERSCHALTELEMENTE, STROMWECHSELRICHTERVORRICHTUNG, ANORDNUNG UND HERSTELLUNGSVERFAHREN
DISPOSITIF DE REFROIDISSEMENT POUR ÉLÉMENTS DE COMMUTATION À SEMICONDUCTEUR, DISPOSITIF D'ONDULEUR, AGENCEMENT ET PROCÉDÉ DE FABRICATION

(43) Date of publication of application: 16.06.2021
(73) Proprietor: Valeo eAutomotive Germany GmbH, 91056 Erlangen (DE)
(72) Inventor: HUCK, Fabian, 90425 Nürnberg (DE); RAYYA, Monzer, 90431 Nürnberg (DE); TRODLER, Dirk, 91227 Leinburg (DE)
(74) Representative: Dr. Gassner & Partner mbB

(56) References cited:
- EP-A2- 2 080 978
- WO-A1-2007/049807
- US-A1- 2015 102 480

## Description

Cooling device for semiconductor switching elements, power inverter device, arrangement and manufacturing method

The present invention relates to a cooling device for semiconductor switching elements, comprising a first main wall for carrying the semiconductor switching elements, a second main wall being opposite to the first main wall, a cooling channel that is defined by the first main wall and the second main wall and allows a coolant to flow along the main walls in a main flow direction, a first side wall and a second side wall each extending from the first main wall, wherein the main flow direction is directed from one of the side walls to the other side wall, and at least one connection channel, which leads into the cooling channel through the second main wall.

Besides, the invention relates to a power inverter device, an arrangement with a power inverter device and with an electric machine and to a method for manufacturing a cooling device.

When operating semiconductor switching elements, exemplarily within a power inverter device that supplies an electric machine of an electric driven vehicle, significant power losses are generated that may cause overtemperature failures of the semiconductor switching elements. It is known to use a cooling device for cooling the semiconductor switching elements that has a cooling channel in order to allow a coolant to flow along the semiconductor switching elements for cooling them. Cooling channels may have two parallel main walls, along which the coolant flows, and connections channels which supply or drain, respectively, the coolant. If the coolant is supplied or drained through one main wall that is opposite to the main wall carrying the semiconductor switching elements, edge regions between the other main wall and a side wall may not be cooled sufficiently.

Prior art is disclosed in documents EP 2 080 978 A2, US 2015/102480 A1 and WO 2007/049807 A1.

Thus, it is an object of the invention to provide an improved possibility for cooling semiconductor switching elements, particularly with respect to applications in electrically driven vehicles.

According to the invention the above object is solved by a cooling device as initially described, wherein at least one guiding device is arranged within the at least one connection channel and configured to direct the coolant towards an edge formed by the first main wall and one of the side walls.

The invention aims to avoid recirculations and/or deadwater regions around the edge by guiding the coolant towards the edge, when the coolant changes its flow direction because of a transition between the connection channel and the cooling channel. Therein, it has to be noted that due to restrictions in a manufacturing process of the cooling device, e.g. casting restrictions, an angle between the second main wall and the connection channel cannot always be formed such that the coolant reaches the edge sufficiently. Thereto, the cooling device according to the invention provides the at least one guiding device that resolves recirculations and guides the coolant into such edge regions. Advantageously, the cooling device provides an easily castable cooling channel and has an increased cooling efficiency realized by the cheap guiding device.

Preferably, a connection channel of the cooling device according to the invention is an inlet channel for supplying the coolant to the cooling channel, wherein a guiding device is arranged within the inlet channel and configured to direct the coolant towards the edge formed by the first main wall and the first side wall. This guiding device may also be regarded as first guiding device. This allows to cool edge regions near the inlet channel. The guiding device may be attached to wall of the inlet channel being opposite to the first side wall.

Therein, the guiding device may comprise a flap being bent into the direction of the edge.

Also, the guiding device may comprise a body having at least one attachment section configured to fix said guiding device in the inlet channel. Therein, an attachment section may be configured to come against the first side wall and/or an attachment section may be configured to come against a wall of the inlet channel being opposite to the first side wall and/or an attachment section may be configured to come against a wall connecting the first side wall and the or a wall of the inlet channel being opposite to the first side wall.

Alternatively or additionally, a connection channel of the cooling device according to the invention is an outlet channel for draining the coolant out of the cooling channel, wherein a guiding device may be arranged within the outlet channel and configured to direct the coolant towards the edge being formed by the first main wall and the second side wall. This allows to cool edge regions near the outlet channel. This guiding device may also be regarded as second guiding device.

Preferably, the guiding device is configured to narrow the outlet channel on a side of the outlet channel being opposite to the second side wall. Thereby, the coolant can be guided nearer towards the edge by prohibiting to flow directly into the outlet channel on the second side wall.

Preferably, the guiding device comprises a flap being bent towards the second main wall.

Alternatively, the guiding device may comprise a flap being bent towards the second side wall. Therein, the guiding device may be attached to a wall of the outlet channel being opposite to the second side wall.

The guiding device may comprises a body having at least one attachment section configured to fix said guiding device in the outlet channel. Therein, an attachment section may be configured to come against the second side wall and/or an attachment section may be configured to come against a wall of the outlet channel being opposite to the second side wall and/or an attachment section or two attachment sections, wherein the or each attachment section may be configured to come against a wall connecting the second side wall and the wall of the outlet channel being opposite to the second side wall and/or one attachment section may be configured to come against a bottom of the outlet channel.

The or each attachment section configured to come against the wall connecting the second side wall and the wall of the outlet channel being opposite to the second side wall may further be configured to come against the second side wall.

According to a specific embodiment, the body of the first guiding device and/or the second guiding device may comprise a bridge section that connects the attachment sections configured to come against the side wall and the wall opposite thereto. The body may further comprise a splitting section that extends from the bridge section along the inlet channel or the outlet channel, respectively, and splits the inlet channel or the outlet channel, respectively, into two parallel parts. Therein, the flap may extend from the splitting section.

With regard to the flap of the first guiding device and/or the flap of the second guiding device, the flap may comprise an attachment member that is bent off and configured to come against the connection channel.

The at least one guiding device may be made of a sheet material, e.g. from plastics or metal.

With respect to the cooling device according to the invention it is preferred that the cooling channel is formed by a cavity within a housing element of the cooling device. Such a cavity can be manufactured with low effort e.g. by casting. The housing element may be made of aluminum for realizing a low weight of the cooling device.

Preferably, the first main wall is formed by a base plate that closes the cavity. The second main wall may be formed by a bottom of the cavity. The at least one connection channel may be formed by through-holes extending from the cavity through the housing element.

According to the invention the above object is furthermore solved by an electrical equipment, comprising a plurality of semiconductor switching elements and a cooling device for the semiconductor switching elements according to the invention. For instance, the electrical equipment is a power inverter device.

According to the invention the above object is furthermore solved by an arrangement comprising an electrical equipment according to the invention, said electrical equipment being a power inverter device, and an electric machine being suitable to drive a vehicle, wherein the power inverter device is configured to supply the electric machine.

According to the invention the above object is furthermore solved by a method for manufacturing a cooling device for semiconductor switching elements according the invention, comprising steps of: casting the housing element so that the at least one connection channel is formed during casting; and arranging the at least one guiding element into the at least one connection channel. All statements referring to the inventive cooling device, the inventive power converter and the inventive arrangement apply analogously to the inventive method so that the above-mentioned advantages may be achieved by the method as well.

Further details and advantages of the invention are disclosed in the following, wherein reference is made to the schematic drawings, which show:
- Fig. 1: a block diagram of an embodiment of an arrangement according to the invention with an embodiment of an electrical equipment according to the invention having an embodiment of the cooling device according to the invention;
- Fig. 2: a longitudinal section of a first embodiment of the electrical equipment;
- Fig. 3: a longitudinal section of a second embodiment of the electrical equipment;
- Fig. 4: a first perspective view of the inlet-side guiding device according to the second embodiment;
- Fig. 5: a second perspective view of the inlet-side guiding device according to the second embodiment;
- Fig. 6: a first perspective view of the outlet-side guiding device according to the second embodiment; and
- Fig. 7: a second perspective view of the outlet-side guiding device according to the second embodiment.

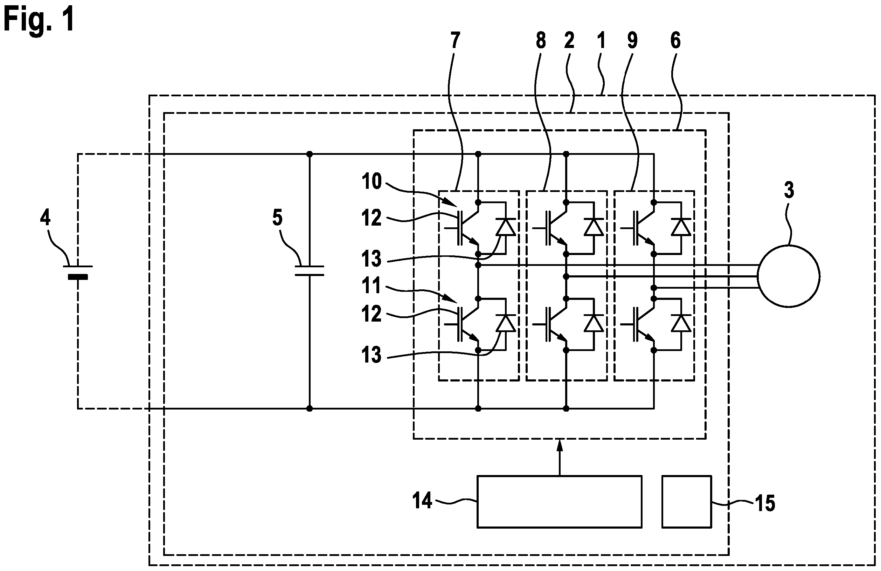

Fig. 1 is a block diagram of an embodiment of an arrangement 1 with an embodiment of an electrical equipment 2 and an electric machine 3. The electrical equipment 2 is a power inverter device that is configured to supply the electric machine 3. The electric machine 3 is suitable for driving a vehicle such as a battery electric vehicle or a hybrid electric vehicle. Furthermore, Fig. 1 shows a high-voltage battery 4 connected to a DC link of the power inverter device or to the arrangement 1, respectively.

The power inverter device comprises a DC link capacitor 5, and a semiconductor switching element module 6 having a first semiconductor switching element arrangement 7, a second semiconductor switching element arrangement 8 and a third semiconductor switching element arrangement 9. Each semiconductor switching element arrangement 7, 8, 9 is configured to provide an output phase current of the power inverter device. Thereto, each semiconductor switching element arrangement 7, 8, 9 comprises a half-bridge formed by two semiconductor switching elements 10, 11. Each semiconductor switching element 10, 11 has a transistor structure 12 and an antiparallel diode structure 13. The transistor structure 12 and the diode structure 13 may be formed by one or multiple Power-MOSFETs or by one or multiple connections of an IGBT and a diode.

Furthermore, the power inverter device comprises a control unit 14 being configured to control the semiconductor switching element module 6 or the semiconductor switching element arrangements 7, 8, 9, respectively, so as to provide a three-phase output voltage. The power inverter device further comprises an embodiment of a cooling device 15 for cooling the semiconductor switching elements 10, 11.

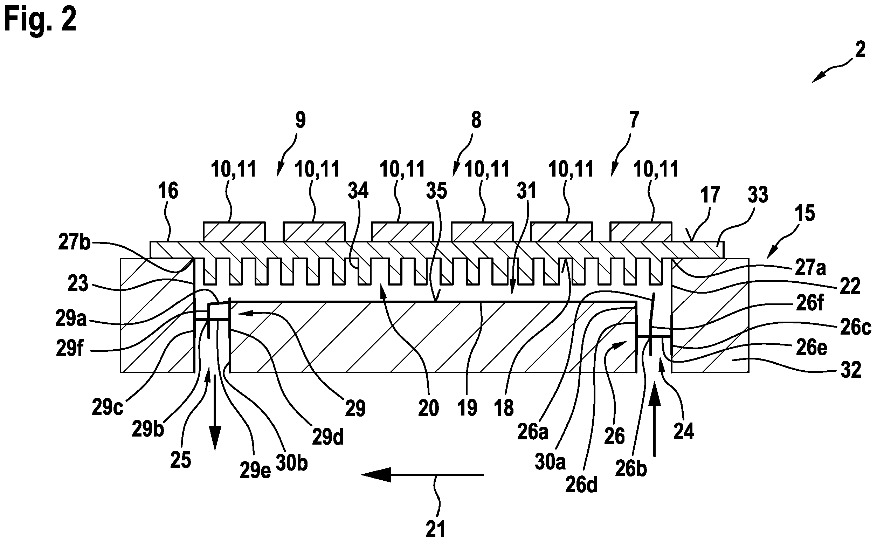

Fig. 2 is a longitudinal section of a first embodiment of the electrical equipment 2.

The cooling device 15 comprises a first main wall 16, which has a first side 17 carrying the semiconductor switching elements 10, 11 and a second side 18 being opposite thereto, and a second main wall 19 being opposite to the first main wall 16. A cooling channel 20 is defined by the second side 18 of the first main wall 16 and the second main wall 19 and allows a coolant to flow along the main walls 16, 19 in a main flow direction 21. Furthermore, the cooling device 15 comprises a first side wall 22 and a second side wall 23 that extend perpendicularly from the first main wall 16 so that the main flow direction 21 is directed form the first side wall 22 to the second side wall 23.

Besides, the cooling device 15 comprises two connection channels, which lead into the cooling channel 20 through the second main wall 19. The first connection channel is an inlet channel 24 for supplying the coolant to the cooling channel 20 and the second connection channel is an outlet channel 25 for draining the coolant out of the cooling channel 20.

Within the inlet channel 24 a first guiding device 26 of the cooling device 15 is arranged. The first guiding device 26 is configured to direct the coolant towards a first edge 27a formed by the first main wall 16 and the first side wall 22. The first guiding device 26 comprises a flap 26a being bent into the direction of the first edge 27a.

Besides, within the outlet channel 25 a second guiding device 29 of the cooling device 15 is arranged. The second guiding device 29 is configured to direct the coolant towards a second edge 27b formed by the first main wall 16 and the second side wall 23. The second guiding device 29 comprises a flap 29a being bent towards the second main wall, therein narrowing the outlet channel 25 on a side of the outlet channel 25 being opposite to the second side wall 23.

As can be seen in Fig. 2 the guiding devices 26, 29 each comprise a body 26b, 29b, from which the respective flap 26a, 29a is bent off. Each body 26b, 26c partially corresponds to a shape of the inlet channel 24 or the outlet channel 25, respectively.

The body 26b of the first guiding device 26 has an attachment section 26c that is attached to the first side wall 22 and an attachment section 26d that is attached to a wall 30a of the inlet channel 24 being opposite to the first side wall 22. Correspondingly, the body 29b of the second guiding device 29 has an attachment section 29c that is attached to the second side wall 23 and an attachment section 29d that is attached to a wall 30b of the outlet channel 25 being opposite to the second side wall 23.

Each body 26b, 29b further comprises a bridge section 26e, 29e that connects the attachment sections 26c, 26d or the attachment sections 29c, 29d, respectively. A splitting section 26f of the body 26b extends from the bridge section 26e along the inlet channel 24 and splits the inlet channel 24 partially into two parallel parts. Therein, the flap 26a extends from the splitting section 26f. Correspondingly, a splitting section 29f of the body 29b extends from the bridge section 29e along the outlet channel 25 and splits the inlet channel 25 partially into two parallel parts. Therein, the flap 29a extends from the splitting section 29f.

Generally, the position of the body 26b of the first guiding device 26 influences the fraction of fluid which is redirected into the deadwater/recirculation region of the prior art. Said position can therefore be used as a design parameter for optimizing the heat exchange.

The cooling channel 20 is formed by a cavity 31 within a housing element 32 of the cooling device 15. The first main wall 16 is formed by a base plate 33 that closes the cavity 31. The second main wall 19 is formed by a bottom 35 of the cavity 31. Therein, the housing element 32 and the base plate 33 are made of aluminum, whereas the guiding devices 26, 29 are made of a sheet material, e.g. plastics or metal.

The inlet channel 24 and the outlet channel 25 are formed by through-holes that are aligned perpendicularly to the second main wall 19. Therein, the through-holes and the cavity 31 are formed by casting the housing element 32. Within restrictions of the casting process it is also possible that the inlet channel and the outlet channel 25 enclose an obtuse angle with the second main wall 19. After casting the housing element 32 the guiding devices 24, 29 are placed into the corresponding connection channels and the cavity 31 is closed by the base plate 33

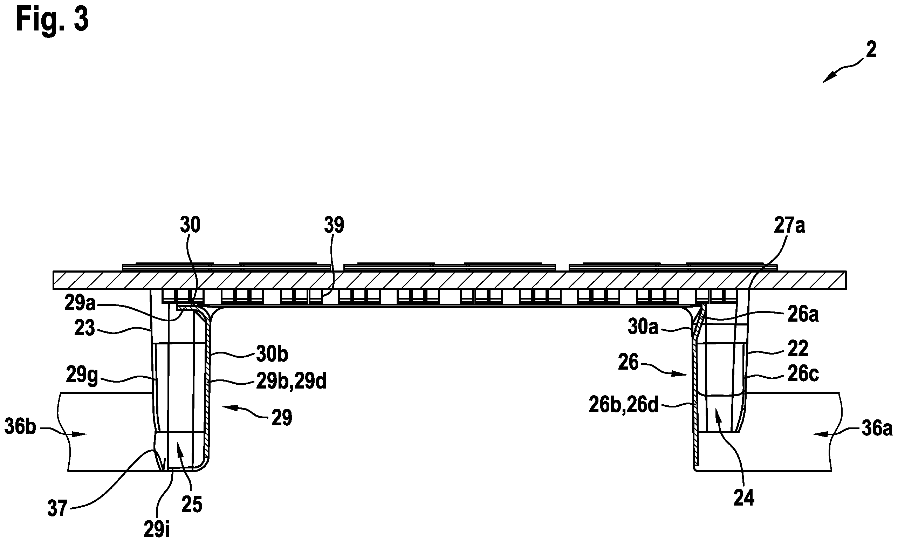

Fig. 3 is a longitudinal section of a second embodiment of the electrical equipment 2. The second embodiment corresponds to the first embodiment unless differences are described in the following. Therein, identical reference signs denote identical or equivalent components.

In the second embodiment the inlet channel 24 is connected to a supply channel 36a. The supply channel 36a extends on an end of the inlet channel 24, said end is opposite to a cooling-channel-side end of the inlet channel 24, substantially in parallel to a plane defined by the first main wall 16. The outlet channel 25 is connected to a drain channel 36b. The drain channel 36b extends on an end of the outlet channel 25, said end is opposite to a cooling-channel-side end of the outlet channel 25, substantially in parallel to the afore-mentioned plane.

According to the second embodiment the flap 26a of the first guiding device 26 extends from the wall 30a being opposite to the first side wall 22 towards the edge 27a. The flap 29a of the second guiding device 29 extends from the wall 30b being opposite to the second side wall 23 towards the second side wall 23.

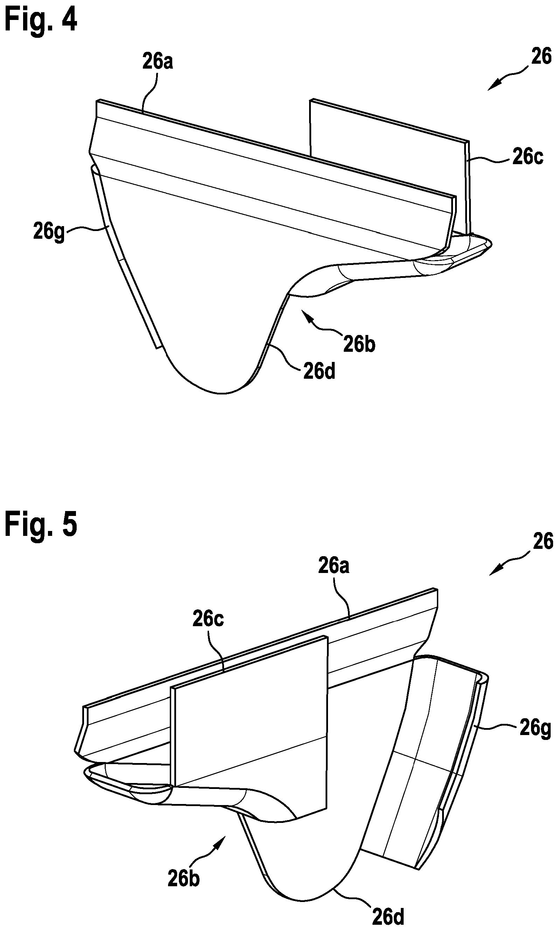

Fig. 4 and Fig. 5 are perspective views of the first guiding device 26 according to the second embodiment.

The attachment sections 26c, 26d of the body 26b have a plate-like shape. The attachment section 26c is attached to the first side wall 22 and the attachment section 26d is attached to the wall 30a (see Fig. 3). The flap 26a is bent off the attachment section 26d. The body 26b has a further attachment section 26g that has the shape of a part of a wall of the inlet channel 24 that connects the first side wall 22 and the wall 30a (see Fig. 3).

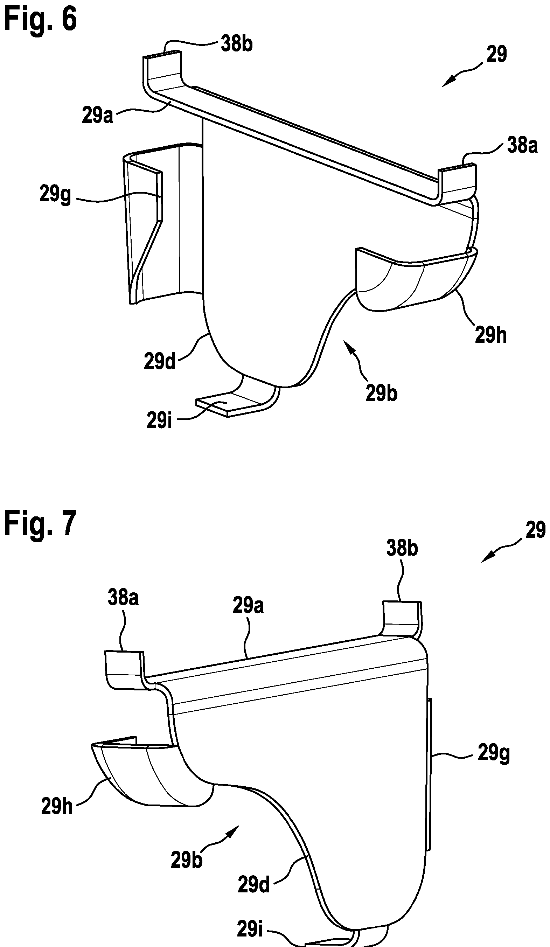

Fig. 6 and Fig. 7 are perspective views of the second guiding device 29 according to the second embodiment.

The attachment sections 29d of the body 29b that is attached to the wall 30b has a plate-like shape. Two further attachment sections 29g, 29h extend from the attachment section 29d. The attachment section 29g is attached to the second side wall 23 as well as to a wall of the outlet channel 25 that connects the second side wall 23 and the wall 30b. The attachment section 29h is attached to second side wall 23 and to the other wall connecting the second side wall 23 and the wall 30b. Another attachment section 29i is provided with the body 29b, which is attached to a bottom 37 of the outlet channel 25. Therein, the bottom 37 may be considered as transition section between the outlet channel 25 and the drain channel 36b.

The flap 29a is provided with two attachment members 38a, 38b that are bent into the direction of the first main wall 16 and attached to the walls connecting the second side wall 23 and the wall 30b.

Optionally, with regard to the afore-mentioned embodiments pin fins 34 (see Fig. 2), ribbon bonds 39 (see Fig. 3) or other heat sink structures are attached the second side 18 first wall 16. Thereby, the guiding devices 24, 29 allow an improved heat transfer from outermost pin fins 34, ribbon bonds 39 or heat sink structures, respectively.

In the above embodiments, the attachment members and/or attachment sections of the guiding devices 26, 29 come against the respective wall to be attached. Alternately, the attachment members and/or attachment sections come against the respective walls, the guiding device 26, 29 being force-fitted in the respective connection channel.

## Claims

1. Cooling device (15) for semiconductor switching elements (10, 11), comprising
- a first main wall (16) for carrying the semiconductor switching elements (10, 11),
- a second main wall (19) being opposite to the first main wall (16),
- a cooling channel (20) that is defined by the first main wall (16) and the second main wall (19) and allows a coolant to flow along the main walls (16, 19) in a main flow direction (21),
- a first side wall (22) and a second side wall (23) each extending from the first main wall (16), wherein the main flow direction (21) is directed from one of the side walls (22) to the other side wall (23), and
- at least one connection channel, which leads into the cooling channel (20) through the second main wall (19),
**characterized in that**
at least one guiding device (26, 29) is arranged within the at least one connection channel and configured to direct the coolant towards an edge (27a, 27b), formed by the first main wall (16) and one of the side walls (22, 23).

2. Cooling device according to claim 1, wherein
a connection channel is an inlet channel (24) for supplying the coolant to the cooling channel (20), wherein a guiding device (26) is arranged within the inlet channel (24) and configured to direct the coolant towards the edge (27a) being formed by the first main wall (16) and the first side wall (22).

3. Cooling device according to claim 2, wherein
the guiding device (26) comprises a flap (26a) being bent into the direction of the edge (27a).

4. Cooling device according to claim 2 or 3, wherein
the guiding device (26) comprises a body (26b) having at least one attachment section (26c, 26d, 26g) configured to fix said guiding device (26c, 26d, 26g) in the inlet channel (24), wherein
- an attachment section (26c) is configured to come against the first side wall (22) and/or
- an attachment section (26d) is configured to come against a wall (30a) of the inlet channel (24) being opposite to the first side wall (22) and/or
- an attachment section (26g) is configured to come against a wall connecting the first side wall (22) and the or a wall (30a) of the inlet channel (24) being opposite to the first side wall (22).

5. Cooling device according to any of the preceding claims, wherein
a connection channel is an outlet channel (25) for draining the coolant out of the cooling channel (20), wherein a guiding device (29) is arranged within the outlet channel (25) and configured to direct the coolant towards the edge (27b) being formed by the first main wall (16) and the second side wall (23).

6. Cooling device according to claim 5, wherein
the guiding device (29) is configured to narrow the outlet channel (25) on a side of the outlet channel (25) being opposite to the second side wall (23).

7. Cooling device according to claim 5 or 6, wherein
the guiding device (29) comprises a flap (29a) being bent towards the second main wall (19) or towards the second side wall (23).

8. Cooling device according to any of claims 5 to 7, wherein
the guiding device (29) comprises a body (29b) having at least one attachment section (29c, 29d, 29g, 29h, 29i), wherein
- an attachment section (29c) is configured to come against the second side wall (23) and/or
- an attachment section (29d) is configured to come against a wall (30b) of the outlet channel (25) being opposite to the second side wall (23) and/or
- an attachment section or two attachment sections (29g, 29h), wherein the or each attachment section (29g, 29h) is configured to come against a wall connecting the second side wall (23) and the or a wall (30a) of the outlet channel (25) being opposite to the second side wall (23) and/or
- an attachment section (29i) is configured to come against a bottom (37) of the outlet channel (25).

9. Cooling device according any of the preceding claims, wherein
the at least one guiding device (26, 29) is made of a sheet material.

10. Cooling device according to any of the preceding claims, wherein
the cooling channel (20) is formed by a cavity (31) within a housing element (32) of the cooling device (15).

11. Cooling device according to claim 10, wherein
- the first main wall (16) is formed by a base plate (33) that closes the cavity (31) and/or
the second main wall (19) is formed by a bottom (35) of the cavity (31).

12. Cooling device according to claim 10 or 11, wherein
the at least one connection channel is formed by through-holes extending from the cavity (31) though the housing element (32).

13. Electrical equipment (2), comprising a plurality of semiconductor switching elements (10, 11) and a cooling device (15) for the semiconductor switching elements (10, 11) according to any of the preceding claims.

14. Arrangement (1) comprising an electrical equipment (2) according to claim 13, said electrical equipment being a power inverter device, and an electric machine (3) being suitable to drive a vehicle, wherein the power inverter device is configured to supply the electric machine (3).

15. Method for manufacturing a cooling device (15) according to any of claims 10 to 12, comprising steps of:
- casting the housing element (32) so that the at least one connection channel is formed during casting; and
- arranging the at least one guiding element (26, 29) into the at least one connection channel.

## Patentansprüche

1. Kühlvorrichtung (15) für Halbleiterschaltelemente (10, 11), umfassend
- eine erste Hauptwand (16) zum Tragen der Halbleiterschaltelemente (10, 11),
- eine zweite Hauptwand (19), die der ersten Hauptwand (16) gegenüberliegt,
- einen Kühlkanal (20), der durch die erste Hauptwand (16) und die zweite Hauptwand (19) begrenzt ist und es einem Kühlmittel ermöglicht, entlang der Hauptwände (16, 19) in einer Hauptströmungsrichtung (21) zu fließen,
- eine erste Seitenwand (22) und eine zweite Seitenwand (23), die sich jeweils von der ersten Hauptwand (16) erstrecken, wobei die Hauptströmungsrichtung (21) von einer der Seitenwände (22) zu der anderen Seitenwand (23) gerichtet ist, und
- mindestens einen Verbindungskanal, der durch die zweite Hauptwand (19) in den Kühlkanal (20) mündet,
**dadurch gekennzeichnet, dass**
mindestens eine Leitvorrichtung (26, 29) innerhalb des mindestens einen Verbindungskanals angeordnet und so konfiguriert ist, dass sie das Kühlmittel zu einer Kante (27a, 27b) leitet, die von der ersten Hauptwand (16) und einer der Seitenwände (22, 23) gebildet ist.

2. Kühleinrichtung nach Anspruch 1, wobei
ein Verbindungskanal ein Einlasskanal (24) zum Zuführen des Kühlmittels zu dem Kühlkanal (20) ist, wobei eine Leitvorrichtung (26) innerhalb des Einlasskanals (24) angeordnet ist und so konfiguriert ist, dass sie das Kühlmittel zu der Kante (27a) leitet, die durch die erste Hauptwand (16) und die erste Seitenwand (22) gebildet ist.

3. Kühleinrichtung nach Anspruch 2, wobei
die Leitvorrichtung (26) eine Klappe (26a) umfasst, die in Richtung der Kante (27a) gebogen ist.

4. Kühleinrichtung nach Anspruch 2 oder 3, wobei
die Leitvorrichtung (26) einen Körper (26b) mit mindestens einem Befestigungsabschnitt (26c, 26d, 26g) umfasst, der so konfiguriert ist, dass er die Leitvorrichtung (26c, 26d, 26g) in dem Einlasskanal (24) befestigt, wobei
- ein Befestigungsabschnitt (26c) so gestaltet ist, dass er an der ersten Seitenwand (22) anliegt und/oder
- dass ein Befestigungsabschnitt (26d) so konfiguriert ist, dass er an einer Wand (30a) des Einlasskanals (24) anliegt, die der ersten Seitenwand (22) gegenüberliegt, und/oder
- dass ein Befestigungsabschnitt (26g) so konfiguriert ist, dass er an einer Wand anliegt, die die erste Seitenwand (22) und die oder eine Wand (30a) des Einlasskanals (24) verbindet, die der ersten Seitenwand (22) gegenüberliegt.

5. Kühlvorrichtung nach einem der vorhergehenden Ansprüche, wobei
ein Verbindungskanal ein Auslasskanal (25) zum Ablassen des Kühlmittels aus dem Kühlkanal (20) ist, wobei eine Leitvorrichtung (29) innerhalb des Auslasskanals (25) angeordnet und so konfiguriert ist, dass sie das Kühlmittel zu der Kante (27b) leitet, die durch die erste Hauptwand (16) und die zweite Seitenwand (23) gebildet ist.

6. Kühlvorrichtung nach Anspruch 5, wobei
die Leitvorrichtung (29) so konfiguriert ist, dass sie den Auslasskanal (25) auf einer Seite des Auslasskanals (25), die der zweiten Seitenwand (23) gegenüberliegt, verengt.

7. Kühlvorrichtung nach Anspruch 5 oder 6, wobei
die Leitvorrichtung (29) eine Klappe (29a) umfasst, die zur zweiten Hauptwand (19) oder zur zweiten Seitenwand (23) hin gebogen ist.

8. Kühlvorrichtung nach einem der Ansprüche 5 bis 7, wobei
die Leitvorrichtung (29) einen Körper (29b) mit mindestens einem Befestigungsabschnitt (29c, 29d, 29g, 29h, 29i) umfasst, wobei
- ein Befestigungsabschnitt (29c) so konfiguriert ist, dass er an der zweiten Seitenwand (23) anliegt und/oder
- dass ein Befestigungsabschnitt (29d) so konfiguriert ist, dass er an einer Wand (30b) des Auslasskanals (25) anliegt, die der zweiten Seitenwand (23) gegenüberliegt, und/oder
- wobei ein Befestigungsabschnitt oder zwei Befestigungsabschnitte (29g, 29h) vorhanen sind, wobei der oder jeder Befestigungsabschnitt (29g, 29h) so konfiguriert ist, dass er an einer Wand anliegt, die die zweite Seitenwand (23) und die oder eine Wand (30a) des Auslasskanals (25) verbindet, die der zweiten Seitenwand (23) gegenüberliegt und/oder
- dass ein Befestigungsabschnitt (29i) ist so konfiguriert, dass er an einem Boden (37) des Auslasskanals (25) anliegt.

9. Kühlvorrichtung nach einem der vorhergehenden Ansprüche, wobei die mindestens eine Leitvorrichtung (26, 29) aus einem Plattenmaterial hergestellt ist.

10. Kühlvorrichtung nach einem der vorhergehenden Ansprüche, wobei der Kühlkanal (20) durch einen Hohlraum (31) in einem Gehäuseelement (32) der Kühlvorrichtung (15) gebildet ist.

11. Kühlvorrichtung nach Anspruch 10, wobei
- die erste Hauptwand (16) durch eine Bodenplatte (33) gebildet ist, die den Hohlraum (31) verschließt und/oder
Dass die zweite Hauptwand (19) von einem Boden (35) des Hohlraums (31) gebildet ist.

12. Kühlvorrichtung nach Anspruch 10 oder 11, wobei
der mindestens eine Verbindungskanal durch Durchgangslöcher gebildet ist, die sich von dem Hohlraum (31) durch das Gehäuseelement (32) erstrecken.

13. Elektrisches Gerät (2), umfassend eine Mehrzahl von Halbleiterschaltelementen (10, 11) und eine Kühlvorrichtung (15) für die Halbleiterschaltelemente (10, 11) nach einem der vorhergehenden Ansprüche.

14. Anordnung (1) mit einem elektrischen Gerät (2) nach Anspruch 13, wobei das elektrische Gerät ein Wechselrichter ist, und mit einer elektrischen Maschine (3), die zum Antrieb eines Fahrzeugs geeignet ist, wobei der Wechselrichter zur Versorgung der elektrischen Maschine (3) konfiguriert ist.

15. Verfahren zur Herstellung einer Kühlvorrichtung (15) nach einem der Ansprüche 10 bis 12, umfassend die folgenden Schritte:
- Gießen des Gehäuseelements (32), so dass der mindestens eine Verbindungskanal während des Gießens gebildet wird; und
- Anordnen der mindestens einen Leitvorrichtung (26, 29) in dem mindestens einen Verbindungskanal.

## Revendications

1. Dispositif de refroidissement (15) pour éléments de commutation à semiconducteur (10, 11), comprenant
- une première paroi principale (16) pour porter les éléments de commutation à semiconducteur (10, 11),
- une seconde paroi principale (19) qui est opposée à la première paroi principale (16),
- un canal de refroidissement (20) qui est défini par la première paroi principale (16) et la seconde paroi principale (19), et permet à un réfrigérant de s'écouler le long des parois principales (16, 19) dans une direction d'écoulement principale (21),
- une première paroi latérale (22) et une seconde paroi latérale (23) s'étendant chacune depuis la première paroi principale (16), dans lequel la direction d'écoulement principale (21) est dirigée d'une des parois latérales (22) à l'autre paroi latérale (23), et
- au moins un canal de connexion qui conduit dans le canal de refroidissement (20) à travers la seconde paroi principale (19), **caractérisé en ce que**
au moins un dispositif de guidage (26, 29) est agencé au sein de l'au moins un canal de connexion et configuré pour diriger le réfrigérant vers un bord (27a, 27b) formé par la première paroi principale (16) et une des parois latérales (22, 23).

2. Dispositif de refroidissement selon la revendication 1, dans lequel un canal de connexion est un canal d'entrée (24) pour fournir le réfrigérant au canal de refroidissement (20), dans lequel un dispositif de guidage (26) est agencé au sein du canal d'entrée (24) et configuré pour diriger le réfrigérant vers le bord (27a) qui est formé par la première paroi principale (16) et la première paroi latérale (22).

3. Dispositif de refroidissement selon la revendication 2, dans lequel le dispositif de guidage (26) comprend un clapet (26a) qui est plié dans la direction du bord (27a).

4. Dispositif de refroidissement selon la revendication 2 ou 3, dans lequel le dispositif de guidage (26) comprend un corps (26b) ayant au moins une section de connexion (26c, 26d, 26g) configurée pour fixer ledit dispositif de guidage (26c, 26d, 26g) dans le canal d'entrée (24), dans lequel
- une section de connexion (26c) est configurée pour reposer contre la première paroi latérale (22) et/ou
- une section de connexion (26d) est configurée pour reposer contre une paroi (30a) du canal d'entrée (24) qui est opposée à la première paroi latérale (22) et/ou
- une section de connexion (26g) est configurée pour reposer contre une paroi connectant la première paroi latérale (22) et la ou une paroi (30a) du canal d'entrée (24) qui est opposée à la première paroi latérale (22).

5. Dispositif de refroidissement selon l'une quelconque des revendications précédentes, dans lequel un canal de connexion est un canal de sortie (25) pour évacuer le réfrigérant hors du canal de refroidissement (20), dans lequel un dispositif de guidage (29) est agencé au sein du canal de sortie (25) et configuré pour diriger le réfrigérant vers le bord (27b) qui est formé par la première paroi principale (16) et la seconde paroi latérale (23).

6. Dispositif de refroidissement selon la revendication 5, dans lequel le dispositif de guidage (26) est configuré pour rétrécir le canal de sortie (25) sur un côté du canal de sortie (25) qui est opposé à la seconde paroi latérale (23).

7. Dispositif de refroidissement selon la revendication 5 ou 6, dans lequel le dispositif de guidage (29) comprend un clapet (29a) qui est plié vers la seconde paroi principale (19) ou vers la seconde paroi latérale (23).

8. Dispositif de refroidissement selon l'une quelconque des revendications 5 à 7, dans lequel
le dispositif de guidage (29) comprend un corps (29b) ayant au moins une section de connexion (29c, 29d, 29g, 29h, 29i), dans lequel
- une section de connexion (29c) est configurée pour reposer contre la seconde paroi latérale (23) et/ou
- une section de connexion (29d) est configurée pour reposer contre une paroi (30b) du canal de sortie (25) qui est opposée à la seconde paroi latérale (23) et/ou
- une section de connexion ou deux sections de connexion (29g, 29h), dans lequel la ou chaque section de connexion (29g, 29h) est configurée pour reposer contre une paroi connectant la seconde paroi latérale (23) et la ou une paroi (30a) du canal de sortie (25) qui est opposée à la seconde paroi latérale (23) et/ou
- une section de connexion (29i) est configurée pour reposer contre un fond (37) du canal de sortie (25).

9. Dispositif de refroidissement selon l'une quelconque des revendications précédentes, dans lequel
l'au moins un dispositif de guidage (26, 29) est réalisé en un matériau en feuille.

10. Dispositif de refroidissement selon l'une quelconque des revendications précédentes, dans lequel
le canal de refroidissement (20) est formé par une cavité (31) au sein d'un élément de logement (32) du dispositif de refroidissement (15).

11. Dispositif de refroidissement selon la revendication 10, dans lequel
- la première paroi principale (16) est formée par une plaque de base (33) qui ferme la cavité (31) et/ou
la seconde paroi principale (19) est formée par un fond (35) de la cavité (31).

12. Dispositif de refroidissement selon la revendication 10 ou 11, dans lequel
l'au moins un canal de connexion est formé par des orifices traversants s'étendant depuis la cavité (31) à travers l'élément de logement (32).

13. Équipement électrique (2), comprenant une pluralité d'éléments de commutation à semiconducteur (10, 11) et un dispositif de refroidissement (15) pour les éléments de commutation à semiconducteur (10, 11) selon l'une quelconque des revendications précédentes.

14. Agencement (1) comprenant un équipement électrique (2) selon la revendication 13, ledit équipement électrique étant un dispositif d'onduleur, et une machine électrique (3) qui convient à entraîner un véhicule, dans lequel le dispositif d'onduleur est configuré pour alimenter la machine électrique (3).

15. Procédé de fabrication d'un dispositif de refroidissement (15) selon l'une quelconque des revendications 10 à 12, comprenant les étapes consistant à :
- couler l'élément de logement (32) de sorte que l'au moins un canal de connexion est formé au cours de la coulée ; et
- agencer l'au moins un élément de guidage (26, 29) dans l'au moins un canal de connexion.
